Europäisches Patentamt

European Patent Office

Office européen des brevets

(11) Publication number: **0 365 854 A2**

## EUROPEAN PATENT APPLICATION

(21) Application number: **89117848.5**

(22) Date of filing: **27.09.89**

(51) Int. Cl.5: **H01L 23/522 , H01L 23/532**

The title of the invention has been amended (Guidelines for Examination in the EPO, A-III, 7.3).

(30) Priority: **27.09.88 JP 241518/88**

(43) Date of publication of application:
**02.05.90 Bulletin 90/18**

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Katsura, Toshihiko**
**c/o Intellectual Property Division K.K.**
**Toshiba**
**1-1 Shibaura 1-chome Minato-ku Tokyo**
**105(JP)**
Inventor: **Abe, Masahiro**
**c/o Intellectual Property Division K.K.**
**Toshiba**
**1-1 Shibaura 1-chome Minato-ku Tokyo**
**105(JP)**
Inventor: **Mase, Yasukazu**
**c/o Intellectual Property Division K.K.**
**Toshiba**
**1-1 Shibaura 1-chome Minato-ku Tokyo**
**105(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) **Semiconductor device having a multi-layered wiring structure.**

(57) A semiconductor device has a multi-layered wiring structure. This semiconductor device has an interlayer insulating film comprising a first insulating film (4) for protecting a first metal wiring layer (3a), a second insulating film (5) deposited on the first insulating film (4) by a substrate-bias applying method to flatten the interlayer insulating film and a third insulating film (6) deposited on the second insulating film (5) to improve the productivity by the same method as used to form the first insulating film (4).

F I G. 3B

## Semiconductor device

The present invention relates to a semiconductor device having a multi-layered wiring structure.

In employing a multi-layered wiring structure for high integration of a semiconductor device, it is recently essential to use a technique for forming an interlayer insulating film flat. As this flattening technique, there is presently known a method for forming a thin film while executing sputtering on the surface of a substrate by applying a DC or AC bias to the substrate. This method includes the so-called bias sputtering method, bias plasma CVD method and bias ECR (Electron Cyclotron Resonance) plasma CVD method. These methods will be hereinafter generally called a substrate-bias applying method. In using these methods, an insulating film is formed to have a laminated film structure comprising an SiO₂ film or SiON film, formed by an ordinary plasma CVD method which generally provides a high productivity, and a film formed by the substrate-bias applying method, in consideration of reducing the leak current of the thin film (the leak current being more than 100 times that of an SiO₂ film formed by an ordinary plasma CVD method (at a measuring temperature of about 200°C)) and improving the productivity.

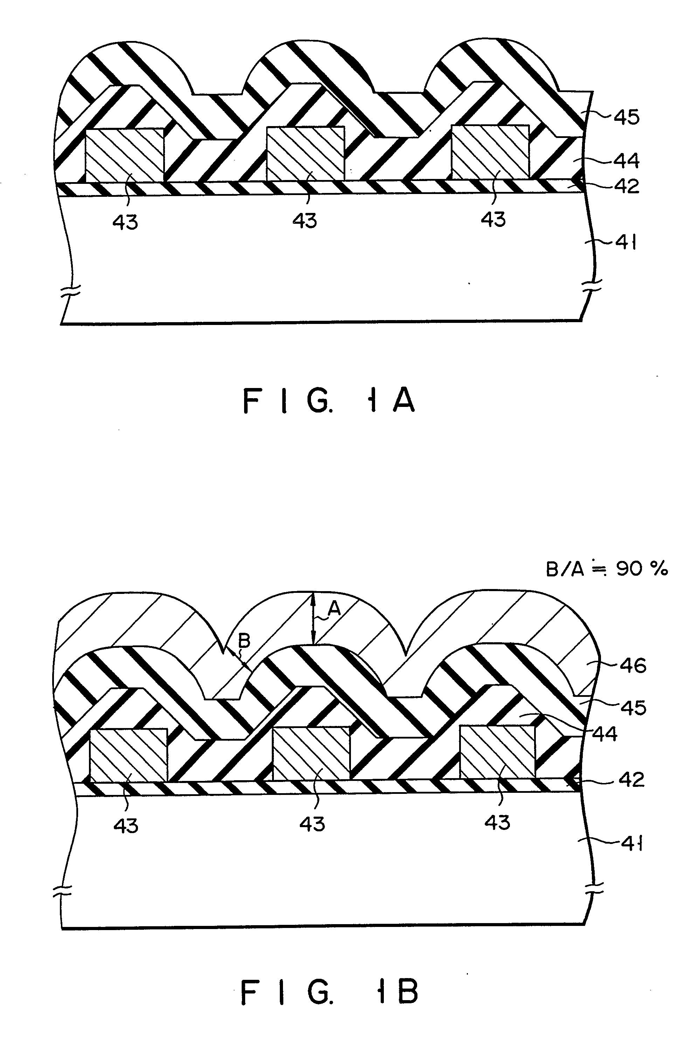

Figs. 1A and 1B illustrate an example of a conventional multi-layered wiring structure. A first insulating film 44 and a second insulating film 45 are deposited on first metal wiring layers 43 formed on a thermal oxide film 42 on a semiconductor substrate 41 (Fig. 1A). The layer 44 is formed by the substrate-bias applying method, and the layer 45 by the ordinary plasma CVD method. A second metal wiring layer 46 is formed on the second insulating film 46 (Fig. 1B).

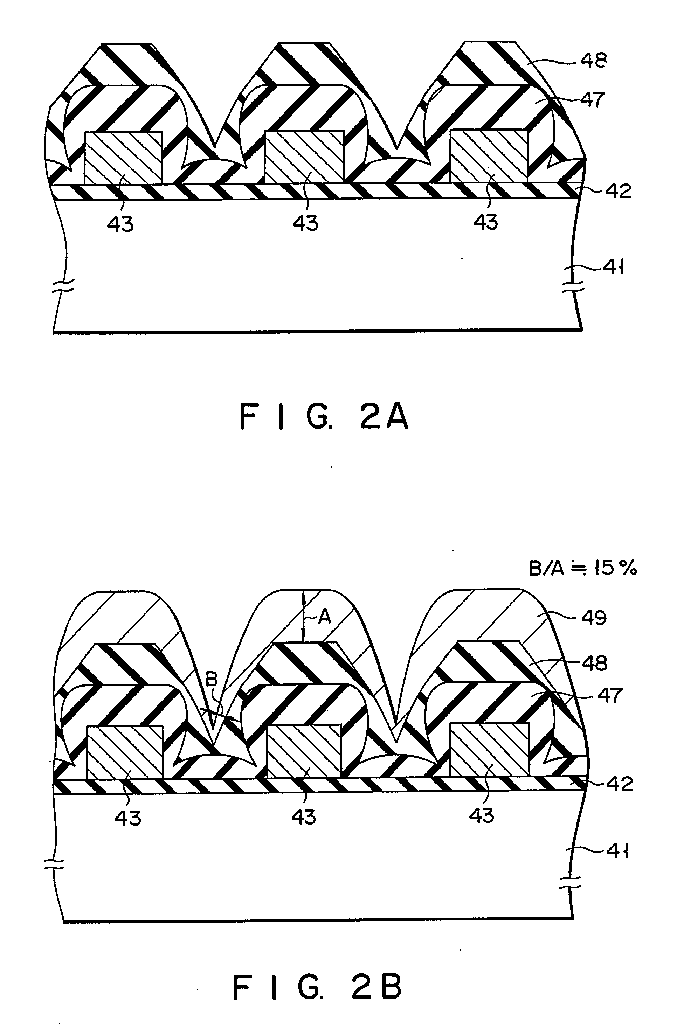

Figs. 2A and 2B illustrate another example of the multi-layered wiring structure. A first insulating film 47 and a second insulating film 48 are deposited on the first metal wiring layers 43 by the ordinary plasma CVD method and the substrate-bias applying method, respectively (Fig. 2A). A second metal wiring layer 49 is formed on the second insulating film 48 (Fig. 2B).

In the first example shown in Figs. 1A and 1B, the positive-ion sputtering/etching effect produced by applying a bias to the substrate (film deposition and etching being simultaneously carried out) are utilized in forming the first insulating film 44 for film flattening. Therefore, a defect is likely to occur on the surface or bulk of the first metal wiring layers 43. Since this defect would cause a stress migration or electromigration, thus resulting in disconnection of the first metal wiring layers 43, it directly influences the reliability of a semiconductor device. In the example shown in Figs. 2A and 2B, although this defect which may occur in the first example, can be avoided, there is insufficient step coverage of the first insulating film 47 at the stepped portion of each first metal wiring layer 43. Even the second insulating film 48 is deposited on the first insulating film 47 by the substrate-bias applying method, therefore, complete film flattening cannot be provided. Accordingly, the step coverage of the second metal wiring layer 49 is deteriorated, thus reducing the reliability of the layer 49.

The conventional semiconductor devices cannot satisfy both improvement of the reliability of the first metal wiring layers and the flattening effect produced by an insulating film.

Accordingly, it is an object of this invention to provide a semiconductor device in which an interlayer insulating film in a multi-layered wiring structure can be formed with a high productivity and with a film flattening effect, without reducing the reliability of the first metal wiring layers.

According to the present semiconductor device, in order to protect the first metal wiring layers, the interlayer insulating film in the multi-layered wiring structure is formed as thin as 500 to 3000 Å by the first insulating film formed in contact with the surface of the first metal wiring layers, such as an SiO₂ film, SiON film, or Si₃N₄ film, formed by the plasma CVD method, or a PSG film, LTO film, spin-on-glass film or polyimide film. Then, the second insulating film is deposited on the first insulating film by the substrate-bias applying method to flatten the interlayer insulating film. The third insulating film is further deposited on the second insulating film by the same method as used for forming the first insulating film, in order to improve the productivity.

With the above structure, since the first insulating film protects the first metal wiring layers, the first metal wiring layers will not be damaged if the second insulating film is deposited on the first insulating film by the substrate-bias applying method. The deposition of the third insulating film on the second insulating film improves the productivity. Further, since the second insulating film is flat, the third insulating film can also be formed flat, thus making the overall interlayer insulating film flat.

This invention can be more fully understood from the following detailed description when taken in conjunction with the accompanying drawings, in which:

Figs. 1A and 1B are cross sections of a conventional semiconductor device;

Figs. 2A and 2B are cross sections of another conventional semiconductor device;

Figs. 3A and 3B are cross sections of a semiconductor device according to the present invention; and

Figs. 4 and 5 are characteristic charts of a wiring protection film of the semiconductor device embodying this invention.

A preferred embodiment of this invention will now be described referring to the accompanying drawings.

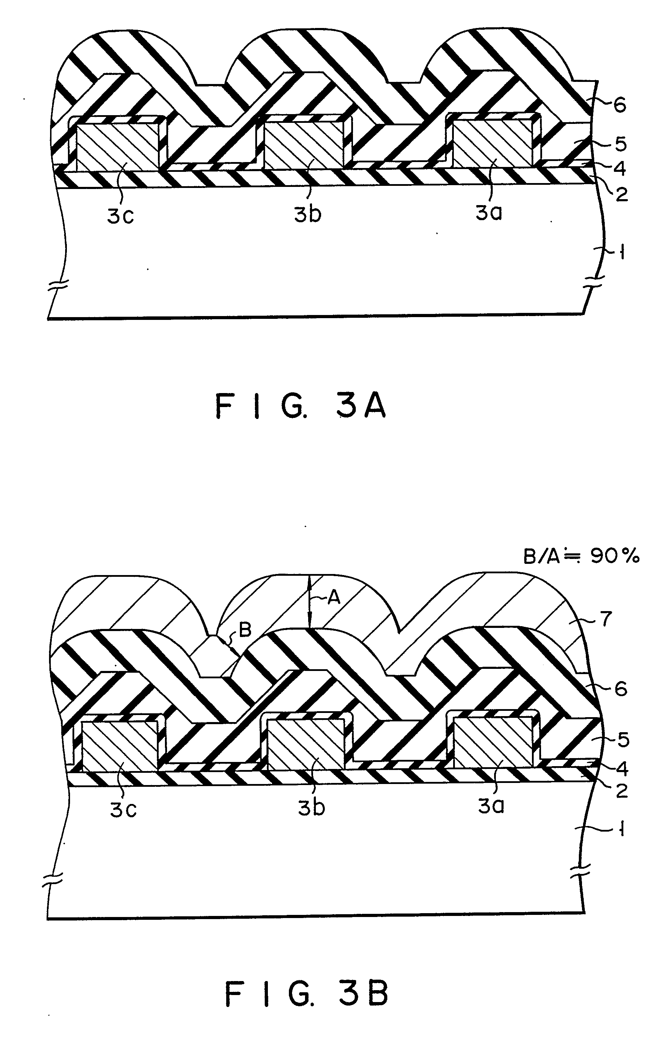

Figs. 3A and 3B are illustrate the cross sections of a semiconductor device embodying the present invention. A thermal oxide film 2 and first metal wiring layers 3a-3c are formed on a semiconductor substrate 1 as per the conventional device. An $SiO_2$ film 4, serving as a protection film to protect the first metal wiring layers, is deposited on the first metal wiring layers 3a-3c by the ordinary plasma CVD method. Another $SiO_2$ film 5 is deposited on this film 4 by the bias sputtering method. An $SiO_2$ film 6 is further deposited on the film 5 by the ordinary plasma CVD method (see Fig. 3A). A second metal wiring layer 7 is formed on the $SiO_2$ film 6 by the sputtering method (see Fig. 3B). With the first metal wiring layers 3a-3c having a thickness of 1.0 μm, a width of 1.5 μm and a layer interval of 2.0 μm, the best thickness of the $SiO_2$ film 4 as the wiring protection film would be 500 to 3000 Å. It should be noted that the first metal wiring layers 3a-3c are formed of Aℓ or Aℓ alloy, an $SiO_2$ film, SiON film, or $Si_3N_4$ film, formed by the plasma CVD method, or a PSG film, LTO film, spin-on-glass film or polyimide film is used as the wiring protection film.

With the above structure, since the wiring protection film is formed covering the first metal wiring layers 3a-3c, these layers 3a-3c would not be damaged if the $SiO_2$ film 5 is formed by the bias sputtering method.

If the interlayer insulating film is formed only by the $SiO_2$ film 5 using the bias sputtering method after forming the wiring protection film, it takes time to produce a semiconductor device and it is therefore impractical. If the interlayer insulating film is formed to have a laminated structure of the $SiO_2$ film 5 and the $SiO_2$ film 6, formed by the ordinary plasma CVD method which yields a high productivity, the productivity of the semiconductor devices can be improved while reducing the leak current.

A semiconductor device according to the present invention was produced and some power-on tests were conducted to evaluate the reliability of the metal wiring layers 3.

First, after the thermal oxide film 2 was deposited approximately 3000 Å on the semiconductor substrate 1 by an ordinary thermal oxidization, an Aℓ-1 wt.% Si film or Aℓ-1 wt.% Si-1 wt.% Cu film of approximately 1.0 μm was formed by the sputtering method. Then, this Aℓ-1 wt.% Si film or Aℓ-1 wt.% Si-1 wt.% Cu film was patterned to have a width/interval = 1.5 μm/2.0 μm, and a length of 2 mm using a photo-lithography or RIE method. Then, the $SiO_2$ film 4 was deposited on the surface of the resultant structure using the ordinary plasma CVD method. Three $SiO_2$ films 4 respectively having thicknesses of 500 Å, 1500 Å and 3000 Å were prepared. The $SiO_2$ film 5 of approximately 8000 Å was deposited on this $SiO_2$ film 4 using the bias sputtering method, and the $SiO_2$ film 6 of 8000 Å was deposited on this $SiO_2$ film 5 using the ordinary plasma CVD method. An Aℓ-1 wt.% Si film of about 1.0 μm thickness serving as the second metal wiring layer 7 was formed on the $SiO_2$ film 6 by the sputtering method.

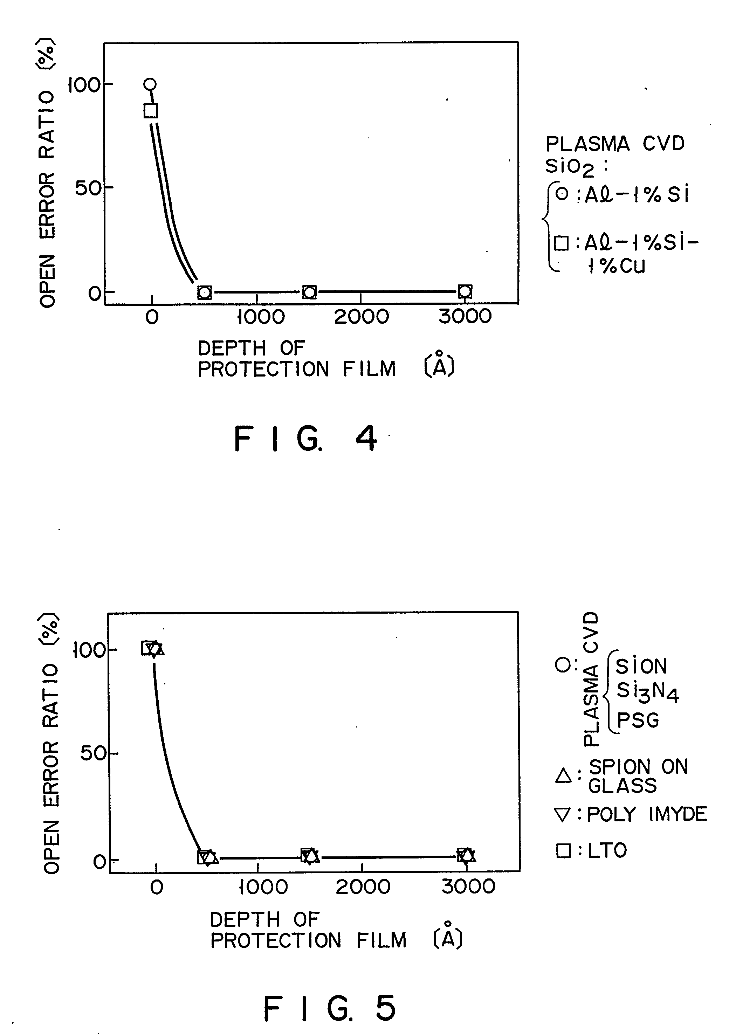

Fig. 4 shows the results of a power-on test conducted on thus constituted semiconductor device under the conditions of an ion density J = 1.0 × 10⁶ A/cm² and a power-on time T = 1000 hours. 100 samples were used for each structure. As illustrated in Fig. 4, the disconnection defect rate is 0 % for the protection film having a thickness of 500 Å or above. This means that no disconnection defect due to electromigration or stress migration had occurred in either the Aℓ-1 wt.% Si film or Aℓ-1 wt.% Si-1 wt.% Cu film. It was found that the step coverage of the protection film at the stepped portion of each first metal wiring layer 3 is satisfactory within a range of 500 to 3000 Å.

The same power-on test was conducted using an $SiO_2$ film, SiON film, or $Si_3N_4$ film, formed by the plasma CVD method, or a PSG film, LTO film, spin-on-glass film or polyimide film as the protection film on the first metal wiring layers 3a-3c comprising an Aℓ-1 wt.% Si film. It was confirmed as shown in Fig. 5 that the same effects as produced by using the $SiO_2$ film 4, formed by the plasma CVD method, as the protection film.

The substrate-bias applying method instead of the bias sputtering method may be used as a method to form an insulating film having the film flattening effect. It should be noted that the present invention can apply to an interlayer insulating film formed between the second metal wiring layer 7 and the third metal wiring layer on the layer 7, when such is a case. In other words, the present invention is effective in forming an interlayer insulating film between wiring layers in a multi-layered wiring structure.

Reference signs in the claims are intended for better understanding and shall not limit the scope.

**Claims**

1. A semiconductor device comprising:
a semiconductor substrate (1);
an oxide film (2) formed on said substrate (1);

a first metal wiring layer (3a) formed on said oxide film (2);

a first insulating film (4), formed on said first metal wiring layer (3a), for protection thereof;

a second insulating film (5) formed on said first insulating film (4) while applying a bias to said substrate (1);

a third insulating film (6) formed on said second insulating film (5); and

a second metal wiring layer (7) formed on said second insulating film (5).

2. A semiconductor device according to claim 1, characterized in that said first metal wiring layer (3a) is an aluminum layer or an aluminum alloy layer.

3. A semiconductor device according to claim 1, characterized in that said first insulating film (4) is an $SiO_2$ film formed by a plasma CVD method.

4. A semiconductor device according to claim 1, characterized in that said first insulating film (4) is an SiON film formed by a plasma CVD method.

5. A semiconductor device according to claim 1, characterized in that said first insulating film (4) is an $Si_3N_4$ film formed by a plasma CVD method.

6. A semiconductor device according to claim 1, characterized in that said first insulating film (4) is a PSG film formed by a plasma CVD method.

7. A semiconductor device according to claim 1, characterized in that said first insulating film (4) is an LTO film formed by a plasma CVD method.

8. A semiconductor device according to claim 1, characterized in that said first insulating film (4) is a spin-on-glass film formed by a plasma CVD method.

9. A semiconductor device according to claim 1, characterized in that said second insulating film (5) is an $SiO_2$.

10. A semiconductor device according to claim 1, characterized in that said third insulating film (6) is an $SiO_2$.

F I G. 1A

B/A ≒ 90 %

F I G. 1B

48

47

42

43          43          43

41

F I G. 2A

B/A ≒ 15 %

A

49

B

48

47

43          43          43          42

41

F I G. 2B

F I G. 3A

B/A ≒ 90%

F I G. 3B

EP 0 365 854 A2

F I G. 4

F I G. 5